# EUROPEAN PATENT APPLICATION

(11) **EP 2 075 828 A1**
(43) Date of publication of application: **01.07.2009**
(21) Application number: 08150775.8
(22) Date of filing: 29.01.2008
(51) Int. Cl.: H01L 21/60, H01L 25/065

(54) **Semiconductor device and a method for aligining and bonding a first and second element for the fabrication of a semiconductor device**

(30) Priority: 27.12.2007 US 17159 P
(71) Applicant: Interuniversitair Microelektronica Centrum (IMEC), 3001 Leuven (BE)
(72) Inventor: Beyne, Eric, 3001 Leuven (BE); Soussan, Philippe, 3000 Leuven (BE); Ruythooren, Wouter, 3150 Tildonk (BE)
(74) Representative: Hertoghe, Kris Angèle Louisa

(57) **Abstract**

The present invention relates to a method for aligning and bonding elements for the fabrication of a semiconductor device, comprising providing a first element with a protrusion, the first element having a front main surface and a back main surface, providing a second element having a front main surface and a back main surface, the second element including a front portion located at the front main surface and a back portion located at the back main surface, providing at least one metal pad, forming at least one blind hole in the second element, the hole extending from the back main surface to the metal pad thereby exposing the metal pad, aligning the protrusion of the first element with the corresponding hole of the second element; inserting the protrusion of the first element into the blind hole of the second element, bonding the protrusion to the metal pad, so that the protrusion makes electrical contact with the metal pad and the first element is bonded to the second element.

## Description

### Technical field of the invention

The present invention relates to a method for aligning and bonding at least a first element and a second element, the elements optionally being selected from the group consisting of singulated dies and wafers each comprising a plurality of dies, for the fabrication of a semiconductor device. The invention also relates to such semiconductor device.

### Background of the invention

This invention applies to the field of 3D Thin Die Packaging or multiple thin IC dies packaging in the semiconductor industry. In currently applied processes the assembly of thin dies is typically performed by welding and/or gluing layers and/or wire bonding.

In a typical wire bonding process wires are bonded to the stacked dies in order to provide electrical connectivity. The wire bonding process is time consuming, relatively complex, and enables only a limited wiring density between the dies. Furthermore, the wire bonding process results in a structure having an essentially "pyramidal" shape, which reduces the useful area of the dies.

Furthermore, stacking of multiple dies normally requires high alignment accuracy. Currently the positioning of the dies is accomplished by equipment that is only capable of achieving poor alignment accuracy. The alignment error is typically of an order of magnitude of about 5 µm or more.

In US 2004/0238933 A1 a packaging method for packaging electronic elements is disclosed. The method comprises the provision of a plurality of stud bumps on a substrate by means of a stud bump process to align with a plurality of vias in another substrate. The stud bumps respectively pass through the vias and electrically connect the electronic elements, thereby creating multiple levels of substrates aligned by the same stud bumps.

This process and the corresponding device have the disadvantage that the alignment is accomplished for the entire stack of elements and depends on the positions of the stud bumps provided on the substrate. Therefore the known process and device do not allow for different alignment of the electronic elements for the respective levels of elements. Furthermore, the positioning of the stud bumps is inaccurate. In fact, the known process relates to relatively large-scaled features on the substrate having dimensions in the order of magnitude of several hundreds of micrometers.

In US 6 577 013 B1 a chip-size semiconductor package ("CSP") containing stacked dies is disclosed. The dies are mounted on one another in a stack such that corresponding ones of vias provided in respective dies are aligned. An electrically conductive wire or pin is present in each set of aligned vias and soldered to corresponding ones of the terminal pads. Therefore the CSP disclosed in this document does not allow for an individual alignment of the dies at the respective levels. Furthermore, the technology that is used does not allow for fine pitch (<20 µm) interconnects.

WO 2004/059720 discloses a set of stacked and interconnected wafers. The wafers are bonded by using a bonding layer of thermoplastic material arranged between the contact surfaces of the wafers. The electrical connections are realized by vias in the wafers connected to studs. The vias extend from the upper surface of the wafer downwards, while the opening for receiving the studs is provided at the back side of the wafer. The studs are received in the openings that have a lateral dimension larger than that of the vias at the front surfaces of the wafers. A drawback of the known method is that it needs a (additional) metallization step to make the openings electrically conductive. Furthermore, the wafer is complex and in the fabrication process a large number of processing steps is needed to accomplish the level of interconnection needed. For example two etching steps (on front and on back) are required, as well as two metal deposition steps - also on the back they put an extra metal layer, indicated with reference number 14. Electrical connections are made by the bottom of the dies, e.g., the connections still require a via connection from the back of the electronic elements to the circuitry. On top of that , the solder material is very close to transistor gates so that special care is required for the passivation of the contact holes.

### Summary of the invention

It is an object of the present invention to provide a good semiconductor device comprising a plurality of aligned and bonded elements such as singulated dies and wafers each comprising a plurality of dies. It is an object of the present invention to provide a method for aligning and bonding at least a first element and a second element, the elements optionally being selected from the group consisting of singulated dies and wafers each comprising a plurality of dies, for the fabrication of a semiconductor device.

It is a further object of the present invention to provide such method and semiconductor device that alleviate or avoid the problems of the prior art.

At least one of the above objects is accomplished by a method and device according to embodiments of the present invention.

According to a first aspect of the invention a method is provided for aligning and bonding at least a first element and a second element, the elements optionally being selected from the group consisting of singulated dies and wafers, each comprising a plurality of dies, for the fabrication of a semiconductor device. The method comprises:
obtaining, e.g. providing, a first element with at least one protrusion, the first element having a first front main surface and a first back main surface and the protrusion being formed at the first front main surface;
obtaining, e.g. providing, a second element having a second front main surface and a second back main surface, the second element including a front portion located at the second front main surface and a back portion located at the second back main surface, the front portion comprising a back-end-of-line interconnection structure comprising at least one metal pad on the second front main surface of the front portion or in the front portion, there being at least one blind hole in the second element, the hole extending from the second back main surface to the metal pad thereby exposing the metal pad, the hole being arranged and construed to be able to receive said at least one protrusion;
aligning the at least one protrusion of the first element with the corresponding at least one hole of the second element;
inserting the at least one protrusion of the first element into the at least one blind hole of the second element; and
bonding the at least one protrusion to the at least one metal pad, so that the at least one protrusion makes electrical contact with the at least one metal pad and the first element is bonded to the second element.

It is an advantage of methods according to the present invention that dies are mechanically assembled together and circuitries are electrically connected with each other directly in one step. This way, a "front-to-front non face-to-face" connection may be obtained. The electrical contacting may be obtained without soldering.

A method according to embodiments of the present invention involves low cost processing steps (simple alignment and bonding steps) and a low level of complexity, while still allowing for a high interconnect density. The method also allows contacting the dies front to front without a need for flipping the second elements. This allows for multiple level stacking with a minimal complexity.

Obtaining a first element may comprise providing a first element with at least one protrusion.

Obtaining a second element may comprise providing a second element and providing the blind hole in the second element.

In an embodiment wherein also the first element includes a front portion located at the first front main surface and a back portion located at the first back main surface, the method may further comprise forming at least one blind hole in the first element, the hole extending from the first back main surface to a metal pad on or in the first element, thereby exposing this metal pad. This first element may then function as a further second element, and the further blind hole is arranged and construed to be able to receive at least one protrusion of a further first element. In this way three or more elements may be easily stacked by simply placing the elements on one another. The elements may be bonded individually, for instance directly after placement, but in other situations it is preferred to bond the elements collectively, for instance after all elements have been properly stacked.

In embodiments of the invention the metal pad on or in the first element may be the earlier-mentioned metal pad on the first front main surface or in the front portion of the first element. In other embodiments, however, the metal pad on or in the first element may be an additional metal pad provided on or inside the front portion of the first element, for instance extending parallel to the metal pad already present in the front portion of the first element.

In further embodiments the hole in the second element extends entirely through the back portion, preferably comprising a front-end-of-the-line (FEOL) structure, and at least partly through the front portion of the second element, the front portion comprising a back-end-of-the-line (BEOL) structure. This means that the major part of the interconnecting path is formed by the protrusion. An advantage thereof is that the signal speed can be higher if it does not transit to the complete FEOL and BEOL.

In further embodiments the height of the at least one protrusion is larger than the depth of the blind hole in the second element so that the second element rests only on the at least one protrusion. The first and second element may then be mutually bonded. In these embodiments the bonds may be formed solely by bonds between the protrusion(s) and the corresponding metal pad(s). The remaining parts of the elements are kept separated from each other.

The height of the protrusions may even be such, that a gap is formed between the second back main surface of the second element and the first front main surface of the first element. Air in this gap may provide for thermal insulation between consecutive elements. At the same time or alternatively, a flow of external cooling fluid (liquid and/or gas) may be generated in the gap to actively cool the elements, if needed. In other embodiments the method may comprise, after having bonded the elements, at least partly filling the gap between the elements with filler material, for instance with thermally insulating material (foam) or, on the contrary, thermally conductive material to provide thermal contact between consecutive elements. The filler material, also called underfill material, also improves the reliability and strength of the semiconductor device, more specifically of the interconnections.

In embodiments of the invention the protrusions and holes are dimensioned and aligned so that a wall of the hole is spaced from the outer surface of the protrusion and is therefore not in contact with the material of the second element. This reduces signal delays and allows for high speed. The spacing (Δs) may for example be between about 1 µm en 2 µm. In some further embodiments, for instance in the embodiments wherein the gap between the elements is filled as described above, the space between the protrusion(s) and the wall(s) of the hole(s) is at least partly filled with filler material as well. For certain applications this will provide a high reliability, as air is kept in small areas.

The material of the protrusion may be an electrically conducting material, preferably metal from the group consisting of Au, Ni, Pd, Co, or Cu.

In embodiments of the invention operation of bonding the protrusion and metal pad may involve any of a heat treatment, a compression treatment or a thermo-compression treatment. When both the protrusion and metal pad are made of Cu, they may preferably be bonded by a Cu/Cu thermo-compression, but other bonding techniques are also feasible. In further embodiments the method may comprise forming a layer of bonding material on top of an upper portion of the protrusion so as to improve the bonding of the protrusion with the metal pad. An example of a suitable bonding material is solder material so that the protrusions may be soldered to their associated metal pads. In a further embodiment for example CuSn transient-liquid phase (TLP) soldering may be employed to firmly bond the protrusions to their metal pads. This type of soldering may lead to a CuₓSn_{y} intermetallic layer after bonding. This type of bonding is consuming part of the metal of the protrusion and the metal contact pad, leaving essentially no Sn unreacted.

In other embodiments the material of an upper portion of the protrusion differs from the material of a lower portion of the protrusion for improved bonding or solder joining, for instance Cu on Ni, Au on Ni, or CU or Sn on Cu or Ni.

A maximum diameter of the protrusions may be about 50 µm or less, for example 10 µm, or for example about 5 µm.

The method may further comprise inserting a plurality of protrusions into a common hole. In this embodiment de mutual distance between protrusion may be comparatively small so that a large number interconnects (formed by the protrusions) may be present on a small area (i.e. a high density of interconnects).

According to other embodiments of the invention the method may comprise providing a plurality of spacing control projections at the first element and corresponding openings in the second element, wherein the spacing control projections are arranged at the first element at offset positions with respect to the respective centres of the openings so as to improve the alignment of the protrusions and holes. The spacing control projections may be offset in a direction away from the centre of the element. The projections can be guided into the openings and may even be allowed to make contact with the side wall (inner surface) of the openings. This ensures registration after placement. If needed, the spacing control projections may provide for a sufficient spacing between each of the interconnects (protrusions) and the walls of the associated openings. In addition, pick-and-place of the elements can be performed at low temperatures (for instance at room temperature) without time overhead for the bonding process. A collective multiple element bonding process may be performed in a next step of the manufacturing process. In a further embodiment wherein all elements have corresponding positions of their openings and projections, multiple elements can be stacked in 3D and a single bonding operation can be applied to bond all elements to one another.

In order keep a well-defined, essentially constant clearance between the interconnects and the walls of the openings the spacing control projections when placed at the corners of the element, may be placed at offset positions. The positions may be shifted in a direction away from the centre of the element, so that the elements are clamped by the respective spacing control projections. The process of fabricating the spacing control projections may differ from the process described herein, but preferably the process is similar.

In embodiments of the present invention, the projections and holes may be formed as protrusions and holes, respectively.

In embodiments of the present invention, the back portion of the second element, and optionally also the first element and/or one or more further elements, may comprise a front-end-of-the-line (FEOL) structure including active components such as transistors and resistors, to be interconnected by wiring in the BEOL portion of the respective element.

According to embodiments of the present invention one or more singulated dies and a wafer (i.e. a die-to-wafer or a wafer-to-die arrangement), a plurality of wafers (i.e. a wafer-to-wafer arrangement) and/or a plurality of dies (i.e. a die-to-die arrangement) may be aligned and bonded.

According to another aspect of the present invention a semiconductor device is provided, the device comprising at least a first element and a second element. The device comprises:
a first element with at least one protrusion, the first element having a first front main surface and a first back main surface and the protrusion being formed at the first front main surface;
a second element having a second front main surface and a second back main surface, the second element including a front portion located at the second front main surface and a back portion located at the second back main surface, the front portion comprising a back-end-of-line interconnection structure comprising at least one metal pad on the second front main surface of the front portion or in the front portion, at least one blind hole being provided in the second element, the hole extending from the second back main surface to the metal pad thereby exposing the metal pad,
wherein said at least one protrusion is aligned with said at least one hole and received therein, the at least one protrusion being bonded to the at least one metal pad, so that the at least one protrusion makes electrical contact with the at least one metal pad and the first element is bonded to the second element.

The first and second elements may be selected from the group consisting of singulated dies and wafers each comprising a plurality of dies.

In embodiments of the invention also the first element may include a front portion located at the first front main surface and a back portion located at the first back main surface. The first element may further comprise at least one blind hole, the hole extending from the first back main surface to a metal pad, thereby exposing the metal pad, wherein the first element functions as a further second element, and the further blind hole has received at least one protrusion of a further first element. In these embodiment one or more further elements is placed on top of the first element to form a multiple element stack.

In a semiconductor device according to embodiments of the present invention, the metal pad may be a metal pad on the first front main surface of the front portion of the first element. Alternatively, the metal pad may be an additional metal pad provided in the front portion of the first element.

In embodiments of the present invention, the at least one blind hole may extend entirely through the back portion and at least partly through the front portion of the second element.

In embodiments of the present invention, the height of the protrusion may be larger than the height of the back portion of the second element.

In embodiments of the present invention, the first and second elements may be mutually bonded solely by their protrusions and corresponding holes. No contact between a main surface of a first element and a main surface of a second element is needed; however, such contact may be present. In embodiments of the present invention, a gap may be provided between the second back main surface of the second element and the first front main surface of the first element. The gap may be, but does not need to be, at least partly filled with filler material. The gap may be used for cooling purposes, e.g. for flowing cooling fluid, e.g. a cooling liquid or a cooling gas, through the gap.

In further embodiments the protrusions and holes may be dimensioned so that a wall of the hole is spaced from the outer surface of the protrusion,
wherein the spacing may or may not be filled with filler material. The protrusions and the holes are shaped and dimensioned so that the spacing (Δs) between the outer surface of a projection and the wall of the hole is between about 1 µm en 2 µm. This distance is related to accuracy of a litho step when forming the protrusions, and to die placement accuracy. The spacing value is preferably rather constant to allow maximum signal speed of the interconnect in the via on a uniform manner The maximum diameter of the protrusions may be about 50 µm or lower, preferably about 10 µm or lower and most preferably about 5 µm. The smaller the maximum diameter of the protrusions, the larger the obtainable interconnect density.

In further embodiments of the present invention, the protrusion is formed on a top surface pad provided at the first front surface of the first element.

In further embodiments of the present invention, the protrusion is made of one or more electrically conducting materials, for example metal from the group consisting of Au, Ni, Pd, Co, or Cu.

In further embodiments of the present invention, an improved bonding of the protrusion with the metal pad is obtained by means of a layer of bonding material. The bonding material may comprise solder material.

In further embodiments of the present invention, the material of a lower portion of the protrusion is different from the material of an upper portion of the protrusion. The material stacks may comprises Cu on Ni, Au on Ni, or Cu or Sn on Cu or Ni.

The bonding between the protrusion and the metal pad may be performed by means of a heat treatment, a compression treatment or a thermo-compression treatment. The bonding may be obtained by means of a soldering treatment.

In further embodiments of the present invention the semiconductor device may comprise a plurality of spacing control projections at the first element and corresponding openings in the second element, wherein the spacing control projections are arranged at the first element at offset positions with respect to the respective centres of the openings so as to improve the alignment of the protrusions and holes, especially when the spacing control projections are offset in a direction away from the centre of the element. The spacing control projections may even contact the inner surface of the openings. In embodiments of the present invention, the spacing control projections may be positioned near the corners of the element.

In embodiments of the present invention the protrusions are non-deformable, so that the gap between the elements may be accurately set by the height of the protrusions. An advantage of having rigid protrusions is that the gap is controlled, which is advantageous for controlling the quality of the underfill process.

In embodiments of the present invention the back portion of the second element, and optionally also of the first element and/or further elements, may comprise a front-end-of-the-line (FEOL) structure including active components such as transistors and resistors, to be interconnected by wiring in the BEOL portion of the respective element.

In embodiments of the present invention the elements are formed by one or more singulated dies and a wafer. In alternative embodiments, the elements are formed by a plurality of wafers. In yet other embodiments, the elements are formed by a plurality of dies.

In embodiments of the present invention, the protrusions form electrical interconnects between the stacked elements.

In embodiments of the present invention, a plurality of protrusions is arranged in a common hole.

Further aspects of the invention are set out in the description and the claims appended hereto. Features from the dependent claims may be combined with features of the independent claims and with features of other dependent claims as appropriate.

Although there has been constant improvement, change and evolution of devices in this field, the present concepts are believed to represent substantial new and novel improvements, including departures from prior practices, resulting in the provision of more efficient, stable and reliable devices of this nature.

### Brief description of the drawings

The following detailed description of embodiments of the present invention will be better understood when read in conjunction with the appended drawings. Further characteristics, advantages and details of the present invention will become apparent from this description. Furthermore, it is to be understood that the present invention is illustrated by way of example only and is not limited by the accompanying figures, in which like references indicate the same or similar elements.

In the description of the embodiments of the invention reference is made to the annexed drawing, in which show:
Fig. 1 a view in cross-section of a wafer according to a first embodiment, in an initial stage;
Figs. 2a and 2b views in cross-section of the wafer of Fig. 1, after a metal pad is provided respectively in the BEOL layer and on top of the BEOL layer of the wafer;
Figs. 3a and 3b views in cross-section of the wafer of Figs. 2a and 2b, after a hole has been etched from the backside and stopping on the meal pad;
Figs. 4a and 4b views in cross-section of respective further wafers, wherein a protrusion has been formed on a top surface pad of each of the further wafers;
Figs. 5a and 5b views in cross-section of respective further wafers according to another embodiment, wherein the upper part of the protrusion is made of a different material;
Figs. 6a and 6b views in cross-section of the operation of placing the wafer of Figs. 4a and 4b or a separate die from a wafer on the wafer shown in Figs. 3a and 3b;
Figs. 7a and 7b views in cross-section of the wafer of Figs. 6a and 6b, after placement;
Figs. 8a and 8b views in cross-section of the wafer of Figs. 5a and 5b, after placement;
Figs. 9a and 9b views in cross-section of the wafer of Figs. 8a and 8b, after soldering;
Figs. 10a and 10b views in cross-section of the operation of placing the wafers of Figs. 3a and 3b or separate dies derived from these wafer on the wafers shown in Figs. 4a and 4b respectively.
Figs. 11 a and 11 b views in cross-section of the wafers of Figs. 10a and 10b, after placement;
Figs. 12a and 12b views in cross-section of the result of the operation of placing the wafers of Figs. 3a and 3b on the wafers shown in Figs. 5a and 5b respectively;
Figs. 13a and 13b views in cross-section of the wafers of Figs. 11 a and 11 b, wherein the gap between the wafers is partly filled;
Figs. 14a-14h views in cross-section of the operation of placing a third wafer on the wafers shown in Figs. 6a and 6b;
Figs. 15a-15d views in cross-section of the operation of filling the gaps between a wafer and a die and between dies in a wafer/die stack;
Fig. 15e a top view of a wafer before singulation into individual dies;
Figs. 16a and 16b views in cross-section of the elements shown in Figs. 13a and 13b;
Figs. 17a-17b schematic top view and side views of an embodiment of a protrusion, showing references to the dimensions of individual portions of the elements;
Fig. 17c a schematic top view of two neighboring protrusions;
Fig. 18 a view in cross-section of the elements of Fig. 6a, showing references to the dimensions of individual portions of the elements;
Fig. 19 a schematic top view of two elements placed on top of each other, the elements being provided with an embodiment of the guiding system according to the present invention;
Fig. 20 a schematic top view showing the different positions of a projection relative to the opening in the embodiment of the guiding system of Fig. 19; and
Fig. 21 schematic top view showing an arrangement with a plurality of protrusions in a common via-hole.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. For instance, if a first element is described as being placed on a second element, it is to be understood that this also encompasses the second element being placed on the first element. More generally, it is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein. Furthermore, the terms die, wafer, substrate, membrane and the like in the description are used for descriptive purposes and are examples of the first element and second element defined in the appended claims. The terms rod, post, pillar, stud and the like are used for descriptive purposes and are examples of the protrusion extending from an element and forming (a part of) the interconnect between the elements. The same applies to the words opening, cavity, via and the like, which are examples of the term "hole" or "via-hole" as used herein.

Furthermore, while some embodiments described herein include some but not other features included in other embodiments, combinations of features of different embodiments are intended to be within the scope of the invention, and form different embodiments, as would be understood by those skilled in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure the understanding of this description.

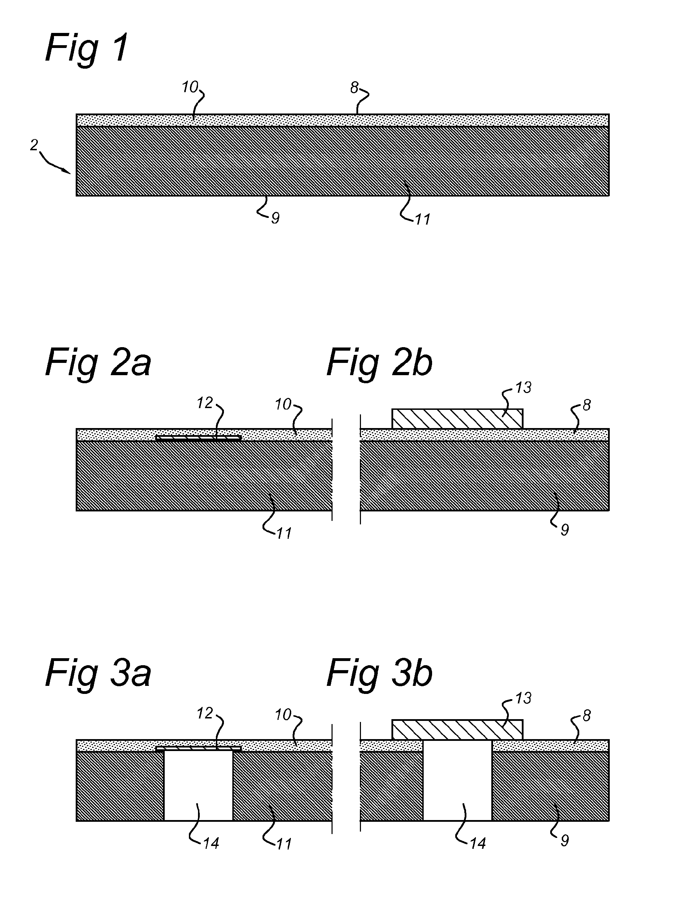

Figs. 1-15 show respective steps of a method for aligning and bonding the elements of a semiconductor device 3 according to embodiments of the present invention. In the figures are shown an element 1 (i.e. the first element, which may be a wafer, a singulated die or any other type of substrate) and another element (i.e. the second element, which likewise may be a wafer, a singulated die or any other type of substrate. Fig. 1a shows a part of the second element 2, in this embodiment a wafer, comprising a number of processed layers on a carrier substrate. The wafer may for example be a Si-wafer, with integrated transistors in a back portion 11 of the wafer, the so-called front-end-of-line (FEOL) structure 11, with subsequently processed interconnect layers, also called the back-end-of-the-line (BEOL) structure 10. The wafer has a front surface 8 and a back surface 9. Inside the front portion 10 of the second wafer, one or more metal elements in the form of metal pads 12, for instance made of copper (Cu) 12 may be machined (cf. Fig. 2a). In the embodiment of Fig. 2a the metal pad is buried in the front portion 10 of the wafer. In other embodiments, for instance shown in Fig. 2b, a metal pad 13 may be processed on top of the BEOL front portion 10 of the second wafer 2. For instance, in the case of advanced CMOS process wafers, the interconnect metallisation in the BEOL structure 10, comprises a metal pad 12 in the front portion of the wafer, whereas for AL-BEOL structures a metal pad 13 is processed on top of the wafer.

In order to realise a three dimensional interconnect possibility with another wafer, first a (blind) via-hole 14 is provided, e.g. etched, from the backside 9 of the second wafer 2. As shown in Fig. 3a, the blind via-hole 14 passes the FEOL back portion 11 and partly the BEOL front portion 10 of the wafer 2 and stops at the buried metal pad 12. In other embodiments the via-hole 14 is etched entirely through the BEOL structure in the front portion 30 of the second wafer and stops at the additionally processed metal pad 13, as is shown in Fig. 3b.

Prior to etching the via-hole 14, the wafer 2 may be thinned to an appropriate thickness in order to limit the aspect ratio of the via-hole 14 and to reduce processing costs. A typical Si-thickness is about 50 micrometer but may generally range from 10 to 300 micrometer. After etching the via-hole 14, a passivation layer (not shown), may be applied to the Si substrate 11. Applying the passivation layer should be done selectively with respect to the metal pad. Possible solutions include selective CVD deposition of Parylene^{™} layers, anodic oxidation of silicon, conformal oxide or nitride deposition followed by anisotropic oxide etching, photo-patternable dielectrics, etcetera.

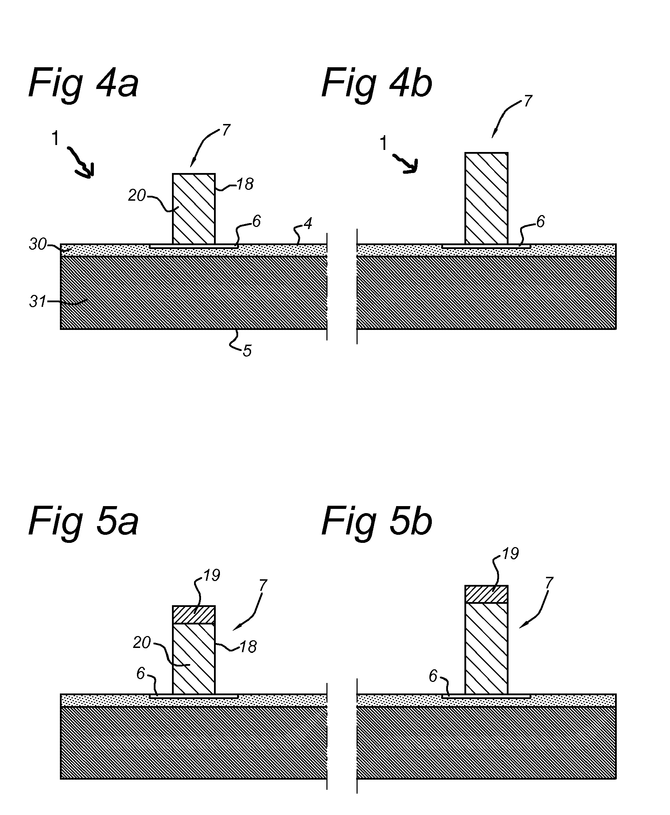

Figs. 4a and 4b show two examples of a first element or wafer 1 of the semiconductor device 3. This wafer has a surface contact pad 6 at locations matching the earlier mentioned via-holes 14 on the second wafer 2. On the surface contact pads 6 a conductive, e.g. metal, pillar or protrusion 7 is provided. The protrusion 7 may for instance be electro-plated on the contact pad 6, but other processes for providing protrusions are feasible as well. The height of the protrusions 7, 7' on the first wafer 1 is slightly larger than the depth of the via-holes 14 in the second wafer 2. Comparing Figs. 4a and 4b one can see that the protrusion 7 of Fig. 4b is slightly higher than the protrusion 7 of Fig. 4a, for reasons that will be discussed hereafter.

In order to ensure a tight control over the height of the different protrusions 7, a planarization method is applied after the electroplating process. One of the preferred materials, e.g. metals of the protrusion(s) 7 is copper (Cu), however other materials could also be used, e.g. Au, Ni, Pd, or Co.

An electroplating process requires to first deposit a metal seed layer, e.g. by physical vapor deposition, comprising an adhesion and barrier layer, e.g. Ti, TiN, Ta, TaN, or thin Cu layer. The next step is the deposition of a thick phororesist layer on this seed layer, and removing the photoresist materials at the required metal protrusion locations by photo-exposure. To realize high density interconnects, a high aspect ratio photo-patternable layer is required. Next, the metal may be electroplated in the patterned photo-resist holes (bottom-up plating). After plating, the photoresist may be stripped from the wafer and the thin seed layer may be removed by etching (wet and/or dry etch). These electroplating processes result inherently in slightly different metal thicknesses as the plating depends on local current densities, pattern uniformity, wafer location, etc. It is therefore recommendable to planarize the metal protrusions prior to further processing. One of the preferred techniques comprises the operation of "fly-cutting" the protrusions 7 at the wafer level resulting in a highly uniform protrusion, in some cases with an accuracy so that the variation across the layer is smaller than 1 µm variation across wafer).

The metal protrusions 7 may be realized as a stack of different conductive, e.g. metal, layers (cf. Figs. 5a and 5b). Different conductive top layers, e.g. metal layers 19, may be present on the upper part 18 of the protrusion 7 and may simplify the joint formation and improve reliability. Examples of top metal layers 19 for improved bonding or solder joining include, but are not limited to Cu on Ni, Au on Ni or Cu, Sn on Cu or Ni.

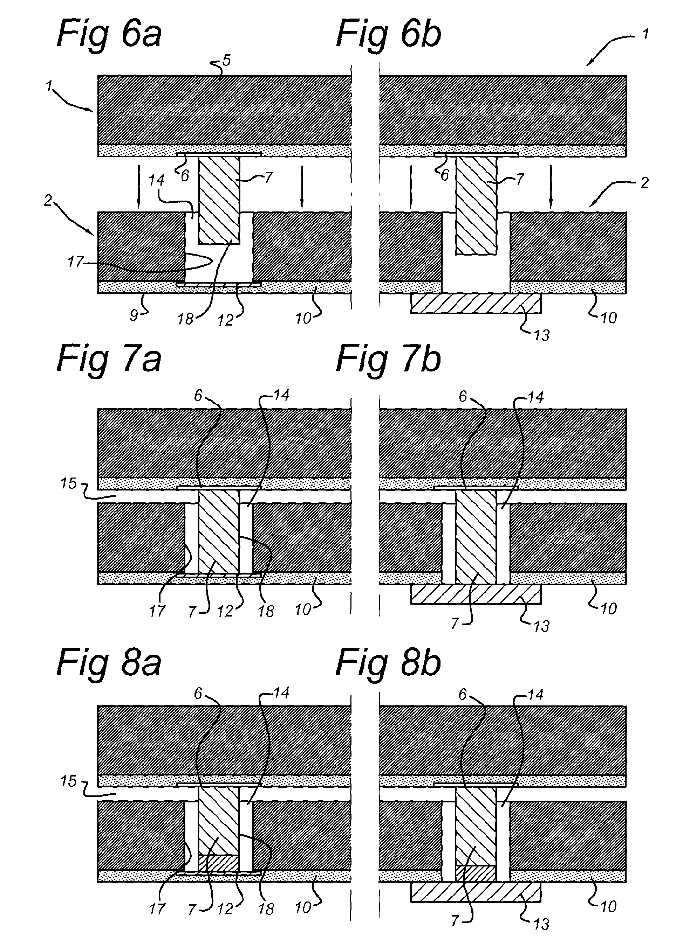

The next step is the actual three dimensional stacking of the wafers 1, 2, as is shown in Figs. 6a and 6b. In these figures the first wafer 1 is aligned with the second wafer and then lowered such that the protrusion 7 is inserted into the respective opening 14 in the back portion 11 and front portion 10 of the second wafer 2 until it contacts the buried metal pad 12 (cf. Fig. 6a) or the surface metal pad 13 (cf. Fig. 6b). Since the depth of the hole 14 shown in Fig. 6b, in case of a metal pad 13, machined on the upper surface 9 of the front portion of the wafer 2, is higher than the depth of the hole 14 in case a metal pad 12 is buried in the front portion 10 of the wafer 2 (cf. Fig. 6b), the height of the protrusion 7 of Fig. 6b should be larger than the height in the other situation. Figs. 7a and 7b show the situation wherein the first wafer 1 of Figs. 4a and 4b have been aligned and placed on top of the second wafer of Figs. 3a and 3b, while Figs. 8a and 8b show the situation wherein the first wafer 1 of Figs. 5a and 5b have been aligned and placed on top of the second wafer of Figs. 3a and 3b.

Although the stacking of two wafers has been discussed, it has to be understood that instead of a wafer also a singulated die can be used. For instance, in the situation shown in Fig. 6a and Fig. 6b, instead of the entire first wafer, one or more dies singulated from the first wafer 1 can be used. In this embodiment the die from the first wafer 1 is aligned using the via-holes of the second wafer 2 (base wafer or base substrate). In a still further embodiment the second wafer 2 has been diced and the fabrication method is realised on individual, singulated dies.

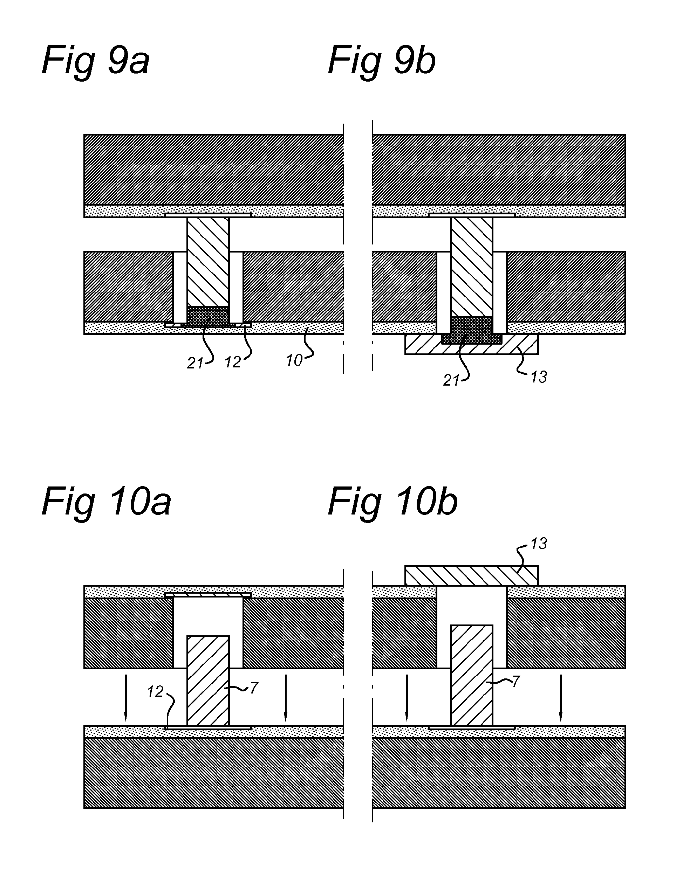

After populating all the locations on the second wafer 2, the protrusions 7 of the first wafer 1 are collectively bonded to the base wafer 2 (or individually in the case of die to die bonding). This bonding operation may involve a thermal treatment, a pressure treatment or a thermal compression treatment. The bonding may be a metal to metal (for instance Cu-Cu) thermal compression bond 19, as is shown in Figs.7a and 7b. The bonding may alternatively also be a solder bond in order to strengthen the bonding between the protrusions and the metal pads, as is shown in Figs. 8a-8b. In Figs. 9a and 9b a further example of a solder bond is given. Herein a CuSn TLP soldering is applied. Transient Liquid Phase (TLP) soldering is a bonding technique which provides the formation of intermetallic phases. The basis for this type of connection is provided by diffusion processes between the metallic materials applied in this soldering process. The soldered layer composite comprises three metallic layers. The two outer layers are composed of a high-melting material and the intermediate layer of a comparatively low-melting material. To ensure a stable and reproducible procedure, the reaction process between the different phases needs a constant joining pressure as well as process temperature which is just slightly above the melting temperature of the low-melting material. In Figs. 9a and 9b is illustrated that a CuₓSₙ metallic layer 21 in the upper end 18 of the protrusion and either the metal pad 12 inside the front portion 10 of the second wafer or the metal pad 13 on top of the front portion 30 of the second wafer 2, is formed. The soldering process consumes a part of the metal from the protrusion and the contact pad, leaving substantially no unreacted Sn.

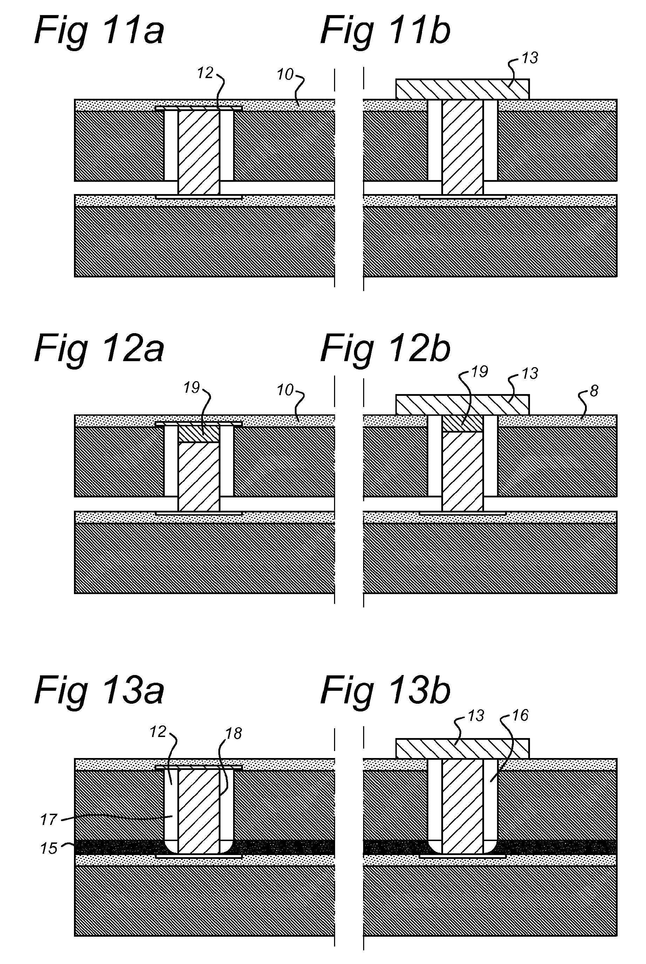

In other embodiments of the invention, a similar process is performed, but in these embodiments it is the second wafer 2 that is lowered down onto the first wafer 1, as is shown in Figs. 10a and 10b. The first element forms a base wafer 1 (or die), on which either another wafer or one or more dies is placed. The bonding operation of securing the projections to the respective metal pads is performed in a similar way as described above, for instance by a thermocompression (cf. Figs. 11 a and 11 b) or a soldering operation (cf. Figs. 12a and 12b). Both mechanical and electrical contact may be obtained without soldering operation. Alternatively, a soldering action may be performed for obtaining the electrical and mechanical contact.

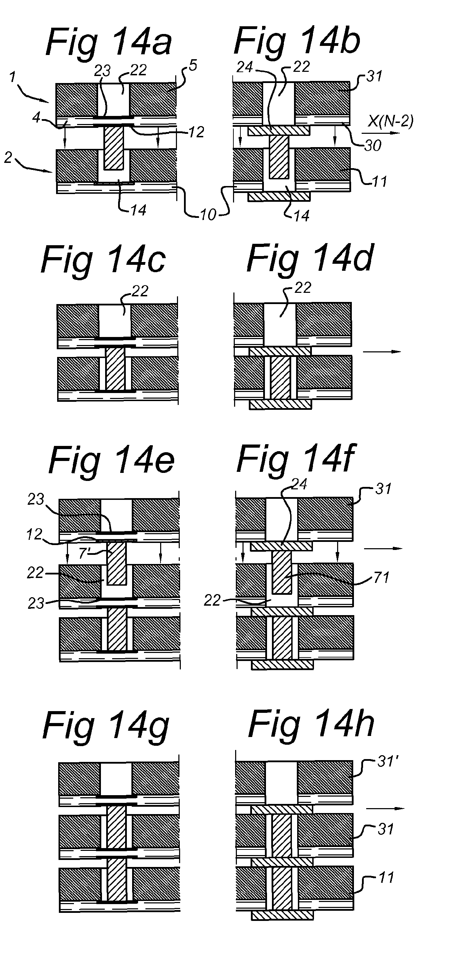

Depending on the height of the protrusions and the depth of the via-holes, a gap may still be present after bonding between the top wafer (that is the first wafer 1 or the second wafer 2) and the pace wafer (that is the second wafer 2 or the first wafer 1). The thickness of this gap may vary slightly, due to the different process tolerances on the depths of the holes, the height of the protrusions and/or any height changes that occur during the bonding process, for instance when using a solder joining method. In further embodiments of the present invention, the gap may be filled with a filler material 15 (cf. Figs. 14a and 14b), for instance a capillary underfill material. The capillary underfill material is dispensed in the gap between the upper surface 4 of the first wafer and the lower surface 9 of the second wafer. During this process the space between 16 the protrusion and the wafer, that is between the outer surface 18 of the protrusion 7 and the wall 17 of the hole 14, is expected to remain void and this means that after filling the gap 19 an air pocket is still present between the protrusion and the wafer.

If the filler material is to be applied in the gap between the wafers, this is in most embodiments performed at the wafer level. Die singulation of the stacks of wafers is then performed after applying the filler material 15. However, in other embodiments the filler material may be arranged between dies of a wafer, after they have been diced. In any case, adding the filler material may improve the reliability and the strength of the interconnect formed by the protrusion(s) 7 and the metal pads 12, 13, 6. Another advantage can be that the material is able to provide a thermal contact between the wafers (or dies) in the stack, thus enabling or improving heat dissipation.

Referring to Figs. 13a and 13b, only the gap between the two wafers (dies) is filled in some embodiments, depending on the interface properties and capillary forces. In other embodiments also the gap around the protrusions 7 may be partially or fully be filled by the filler material. The filler material filling the gap between the two wafers (dies) may be the same material as the material filling the gap around the protrusions 7. Alternatively, other filling material may be used.

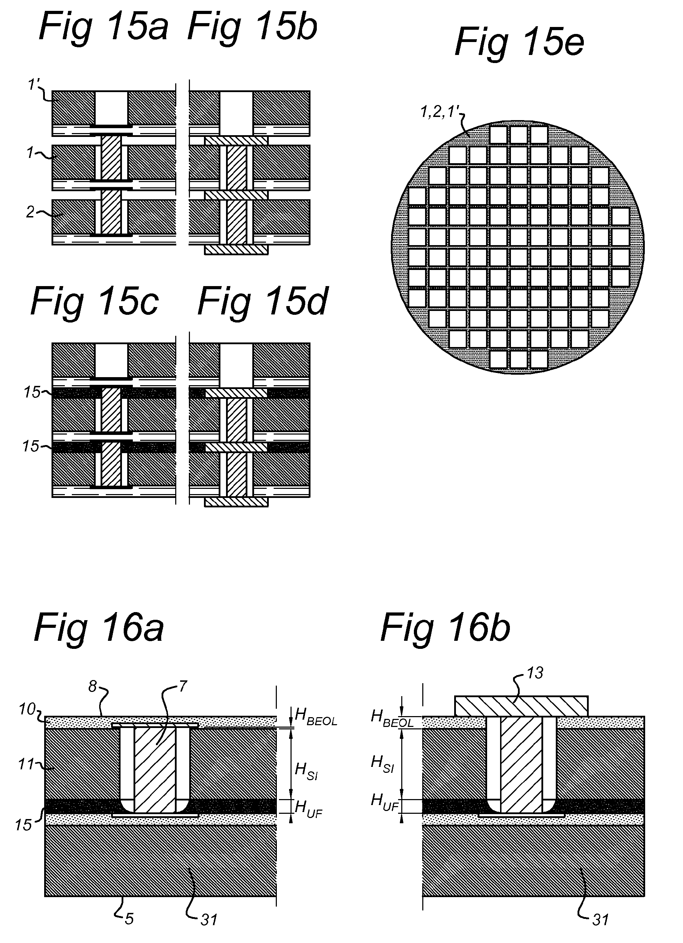

In Figs. 14a-h and Figs. 15a-e the process of stacking multiple elements (wafers/dies) is shown. Figs. 14a and 14b show that in the first element 1 one or more via-holes 22 are machined similar to the via-holes 14 originally machined in the second wafer 2. The further via-holes 22 extend to a metal pad which is exposed to the hole 22 so that electrical contact can be made. In the embodiment of the first wafer wherein a metal pad is placed inside the front portion 30, use can be made of the existing metal pad 12 or, preferably, of an additional metal pad 23 provided in another part of the front portion 30 of the first wafer. The first and second element 1, 2 are then aligned and placed on top each other as described earlier (cf. Fig. 14c).

Referring now to Fig. 14e, in the additional via-holes 22 corresponding protrusions 7 of a further first element 1' can be arranged. The resulting set of stacked elements 1, 2, 1' is shown in Fig. 14g.

A corresponding case arises, in case of embodiments wherein the metal pad 13 of the first wafer is placed on top of the front portion 30 of the first element (cf. Fig. 14b). A hole 22 is made such that it extends through the back portion 31 and the front portion 30 until it reaches the metal pad 13. In the same manner as discussed before, the further element 1', having provided thereon a metal pad 13 and a protrusion 7' of a further wafer 1' (cf. Fig. 14d) may be placed on top of the original first wafer 1. The resulting set of stacked elements 1, 2, 1' is shown in Fig. 14h.

Although in Figs. 14a-h is shown that the further element 1' is of the original first element type, that is without having a hole 14, 22 in the back portion thereof, the further first element 1' could also be provided with a via-hole 22, so that even more than three wafers can be stacked on top of each other.

In other embodiments of the present invention, a multiple die (wafer) stacking is achieved by using a first or second wafer as a base wafer, in which different dies 1,1' are placed in the above-described manner (Fig. 14a-h). Once all the dies have been placed on top of the base wafer, the filler material 15 is arranged in the gaps between respectively the second and first element (that is a wafer and a die), and between the further element and the first element (cf. Figs. 15a-15e). Only after all the elements of the stack have been placed and the gaps between the elements have been filled with filler material, a stack singulation step (dicing step) is performed to provide a plurality of interconnected individual dies.

When the protrusions of an element (for instance a wafer or die) are placed in the holes made in a base element (wafer or die) (or the via-holes of one wafer/die are placed over the protrusions plated in a bottom wafer or die), this can be performed, preferably at room temperature, by a pick-and-place unit, known as such in the art. No specific bonding process is required after placement, therefore the process of the placement of the elements can be completed before the next step of bonding the element is to be performed. However, when moving the elements (wafers/dies) to the bonding tool, it is possible that the components slightly move, thereby causing the protrusions to contact the material (in most cases silicon) of the wall of the respective holes. To avoid this problem, or, more generally, to offer an improved alignment of the elements and to keep the alignment during the movement from the pick-and-place unit to the bonding tool, a further guiding system comprising one or more guiding pins or spacing control pins to be inserted in corresponding openings in the elements, is provided.

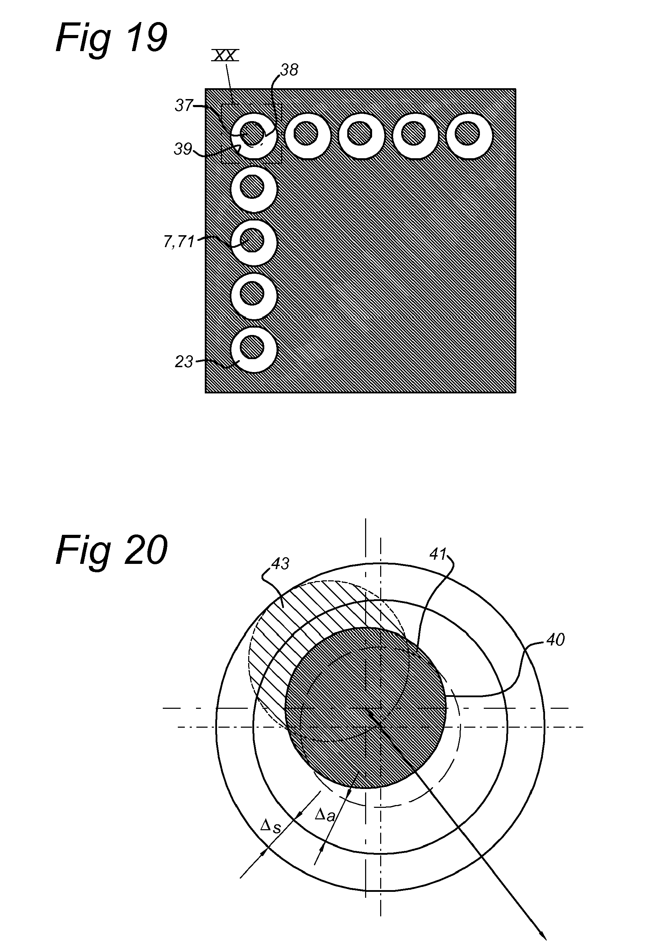

Fig. 19 shows an embodiment of a guiding system according to the present invention. One or more spacing control projections or pins 37 are formed at the surface of one of the elements, for instance a first element 1 (although the projections may additionally or alternatively be formed at a second element 2). In the opposite element 2 (or 1) openings 38 are provided at positions corresponding with the positions of the projections 37. The openings 38 are dimensioned so as to be able to receive the projections 37.

In the manner described herein the elements have also been provided with a number of protrusions 7 to be received in holes 14, the protrusions forming interconnects between the elements involved. In preferred embodiments of the invention the manufacturing process of the spacing control projections 37 and the openings 38 is similar to the manufacturing process of the earlier-mentioned protrusions 7, 7' and via-holes 14, 22. However, the positions at which the projections 37 are placed is slightly offset with respect to the position expected when the projection would have been a protrusion acting as an interconnect for the elements.

The offset position is shown in more detail in Fig. 20. The projections 37 have been shifted in a direction away from the centre of the elements (die centre) with a value about equal to the minimal spacing (As) between the protrusion 7, 7' and the wall of the via-holes 14, 22. The minimal spacing is the minimal distance that should be kept between the outer surface of a protrusion 7 and the wall 17 of the opening 14 to ensure that the protrusion does not make contact with the wall.

As is shown in Fig. 19, the spacing control projections are preferably placed close to the die corners so that the protrusions can provide for a strong fixation of the projections in the openings. Placing the projections additionally or alternatively at other positions is also conceivable.

In Fig. 20 the offset position is shown as a shift from the nominal protrusion position 40 to the Δs off-centre protrusion position 41. In the Δs off-centre protrusion position the projection 37 may or may not contact the inner wall 39 of the opening 38. In any case, the position of the projection 37 should be within the alignment tolerance (Δa) with which the elements should be aligned to one another. In Fig. 20, the reference numbers 41 and 43 denote respectively a projection shifted over a distance Δs from the nominal projection position 40 and a worst case position of the projection 41. In any case, the shifted position of the projections 37 relative to the wall 39 of the opening 38 ensures that the elements keep being aligned within the alignment tolerance Δa, even during movement of the elements from the pick-and-place unit to the bonding tool.

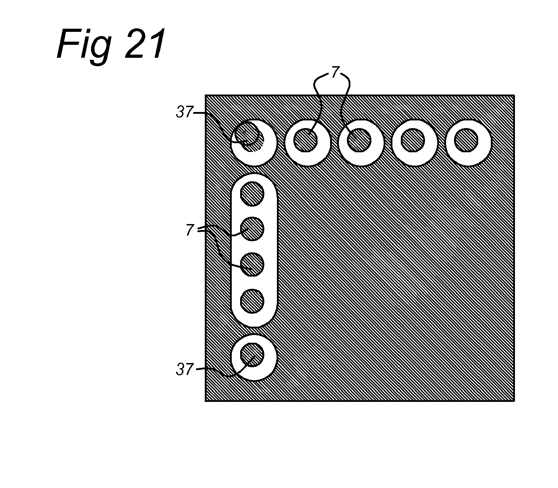

In order to increase the density of the interconnecting projections (i.e. to increase the number of projections per area unit), it is possible, in further embodiments, to arrange a plurality of protrusions 7,7' in a common via-hole 33, as illustrated in Fig. 21. In these embodiments the tolerances to be met only apply to the outer dimensions of the sum of the projections and therefore it is possible to reduce the average spacing between the protrusions 7,7'. The reduction of the average spacing between the protrusions gives rise to an increase of the density of the interconnects between the elements.

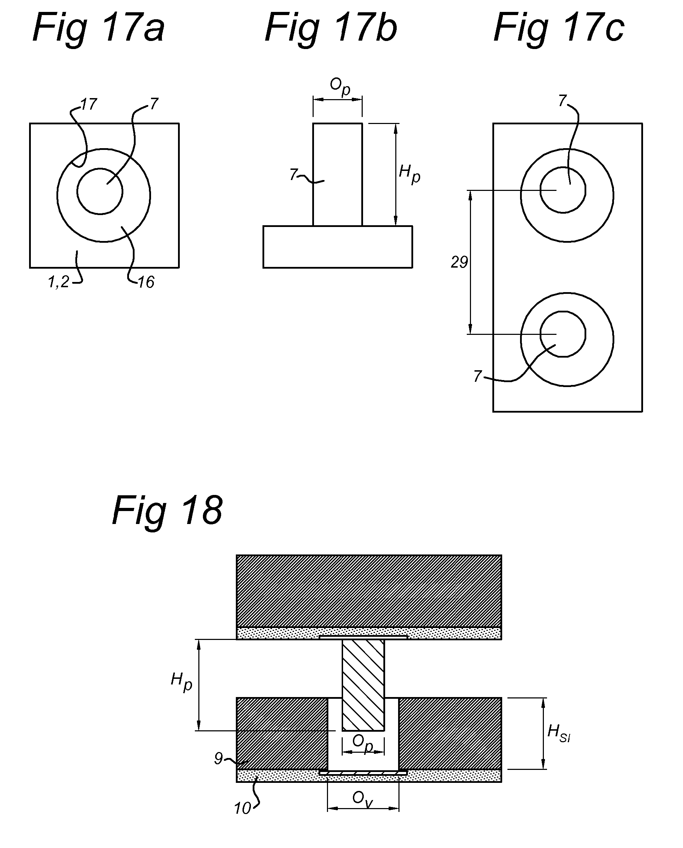

Figs. 16a-16b, 17, 18 show the typical dimensions of an embodiment of a semiconductor device fabricated in accordance with the invention. The required height of the metal post, HP, depends on:
- The thickness HSi of the back portion 11, 31, i.e. the Si thickness, after the element has been thinned, base wafer typically <300 µm, wafers/dies in stacks approximately 50 µm, possibly down to 10 µm;
- The depth HBEOL of the via-hole 14 in the BEOL interconnect layers (structure 10 in the second element 2, structure 30 in case of a further element 1') ranging from less than 1 µm when using a metal pad 12,23 buried in the front portion 10,30 of the element 2,1' (shown in Fig. 16a) and ranging from 1 µm to up to 10 µm when using metal pads 13 on top of the element (in some embodiment on top of the passivation layer); and
- The thickness of the underfill layer, HUF, ranging from about 5 to 50 µm.
- The height HP (cf. Fig. 17b) of the protrusion 7,7' is HP = HSi + HBEOL + HUF and ranges from 15 to 350µm, preferably from about 50 µm to 100 µm.

Similarly, the required diameter of the metal post, ØP (cf. Fig. 17a and 17b), depends on the following requirements. The metal post (protrusion) should preferably not come in contact with the back portion of an element, more specifically the Si part thereof. The required space 16 (cf. Fig. 17a) between the outer surface 18 of the post 7,7' and the wall 17 of the via-hole should therefore be made dependent on the placement accuracy of the pick-and-place unit (for instance a die-to-wafer or wafer-to-wafer assembly tool) that is employed to pick up the elements and to stack the same. Today this accuracy varies from 1 µm for flip chip bonders (slow) to 10 µm for pick-and-place tools (fast). It is expected, however, that in the future the accuracy may increase.

In addition, a worst case clearance between the metal post 7,7' and the Si wall of the hole 14 has to be guaranteed, typically about 1 to 2 µm. The diameter of the metal post (protrusion) is also defined by the aspect-ratio capabilities of the Si-via-hole and the metal protrusion formation processes. Process complexity increases as these aspect ratios increase. The main constraint comes from the metal protrusion formation process (smallest diameter). Typical aspect ratios would vary from 2:1 to 10:1.

One of the purposes of the via-holes (or through-silicon vias TSV) 14 is to connect I/O structures at the bond-pad level. The pitch (29, cf. Fig. 17c) of these contacts typically vary from 100 µm down to 60 µm and will scale to 40 µm and eventually 20 µm (ITRS). This also defines a limit for the via-hole size, i.e. about 10 µm smaller than the pitch, the diameter of the hole from e.g. 90 µm down to 50 µm (typical), further scaling down to 30 µm and eventually 10 µm. The above considerations result in a metal protrusion diameter of max. 50 µm, typically from about 20 to 25 µm, down to 10 µm and eventually 5 µm, as is shown in Table I below.

**Table I Typical dimensions for the Cu-pillar and via holes are:**

| I/O pitch (µm) | Via cavity Øv (µm) | Placement tolerance (µm) | Spacing margin (µm) | Cu pillar Øp (µm) | Silicon thickness (µm) | Underfill thickness (µm) | Cavity depth (M1) (µm) | Pillar heght (µm) | AR Si cavity | AR Metal Pillar |
|---|---|---|---|---|---|---|---|---|---|---|
| 100 | 90 | 10 | 10 | 50 | 50 | 20 | 51 | 71 | 0.57 | 1.42 |
| 60 | 50 | 10 | 5 | 20 | 50 | 10 | 51 | 61 | 1.02 | 3.05 |
| 40 | 30 | 5 | 2.5 | 15 | 50 | 10 | 51 | 61 | 1.70 | 4.07 |
| 20 | 15 | 2 | 2 | 7 | 50 | 5 | 51 | 56 | 3.40 | 8.00 |

It is to be noted that the indicated silicon thickness may be taken smaller, but when the thickness is of the order of magnitude of 50 µm, this allows for carrier-less processing (i.e. pick-and-place) of single dies. Regarding the cavity depth (i.e. the depth of the via-hole 14), it is to be understood that in those embodiments wherein a metal pad 13 provided on top of the element, the depth of the cavity 14 and the height of the protrusion 7 may have to be increased by about 4 - 10 µm. The height of the gap (in the table called the "underfill thickness") is not critical. The values 10-20 µm allow for variance of the absolute height of the protrusions. However, smaller values for the gap thickness are also feasible.

In embodiments of the invention the method is mainly aiming at die-to-wafer or die-to-die stacking. In order to effectively stack multiple dies to a wafer, two process steps need to be performed. First of all, a pick-and-place unit should pick-up one or more dies and place them on top of a base wafer and, if more than two dies have to be stacked, on top op each other. In this step the wafer and dies are aligned and the protrusions are inserted into their associated holes (or the holes are placed over the corresponding protrusions). In this stage a relatively stable arrangement of wafers and dies may be accomplished. In a second step, the protrusions are bonded permanently to the metal pads causing the dies to be secured to the base (bottom) wafer.

Although the step of bonding may be performed each time two elements (for instance a die on a wafer or a die on another die) have been correctly aligned and stacked, in some embodiments this step is performed only after all elements have been aligned and stacked. The time required for actual bonding (thermo-compression or solder reflow) is much larger than a that of the single element alignment and element placement step. The bonding is then performed as a collective multiple element (multiple die/wafer) bonding operation.

Although the invention has been described with reference to specific embodiments, specific constructions and configurations, as well as materials, thereof, it will be appreciated that invention is not limited to these embodiments and that changes and modifications to the system and method described herein may be made without departing from the scope of the invention as defined by the appended claims.

## Claims

1. Method for aligning and bonding at least a first element and a second element for the fabrication of a semiconductor device (3), the method comprising:
obtaining a first element (1) with at least one protrusion (7), the first element (1) having a first front main surface (4) and a first back main surface (5) and the protrusion being formed at the first front main surface (4);
obtaining a second element (2) having a second front main surface (8) and a second back main surface (9), the second element (2) including a front portion (10) located at the second front main surface (8) and a back portion (11) located at the second back main surface (9), the front portion (10) comprising a back-end-of-line (BEOL) interconnection structure comprising at least one metal pad (12,13) on the second front main surface (8) of the front portion (10) or in the front portion (10), there being at least one blind hole (14) in the second element (2), the hole (14) extending from the second back main surface (9) to the metal pad (12,13) thereby exposing the metal pad, the hole being arranged and construed to be able to receive said at least one protrusion (7);
aligning the at least one protrusion (7) of the first element (10) with the corresponding at least one hole (14) of the second element (2);
inserting the at least one protrusion (7) of the first element (1) into the at least one blind hole (14) of the second element (2);
bonding the at least one protrusion (7) to the at least one metal pad (12,13), so that the at least one protrusion (7) makes electrical contact with the at least one metal pad (12,13) and the first element (1) is bonded to the second element (2).

2. Method as claimed in claim 1, wherein also the first element (1) includes a front portion (30) located at the first front main surface (4) and a back portion (31) located at the first back main surface (5), the front portion (30) of the first element (1) comprising a further back-end-of-line (BEOL) interconnection structure.

3. Method as claimed in claim 2, comprising:
forming at least one further blind hole (22) in the first element(1), the further blind hole (22) extending from the first back main surface (5) to a metal pad (23, 24) on or in the first element, thereby exposing the metal pad on or in the first element, the further blind hole (22) being arranged and construed to be able to receive at least one protrusion (7) of a further first element (1').

4. Method as claimed in claim 3, wherein the metal pad in the first element (1) is an additional metal pad (23) provided in the front portion (30) of the first element (1).

5. Method as claimed in any of the preceding claims, comprising repeating the operations as claimed in any of claims 1-5 to form a stack of more than two elements (1,2,1').

6. Method as claimed in any of the preceding claims, wherein the hole (14) in the second element (2) extends entirely through the back portion (11) and at least partly through the front portion (10) of the second element (2).

7. Method as claimed in any of the preceding claims, wherein the height of the at least one protrusion (7) is larger than the depth of the blind hole (14) in the second element (2).

8. Method as claimed in any of the preceding claims, wherein the first and second element (1,2) are mutually bonded only by their protrusions (7) and holes (14).

9. Method as claimed in any of the preceding claims, comprising forming a gap (15) between the second back main surface (9) of the second element (2) and the first front main surface (4) of the first element (1).

10. Method as claimed in claim 9, comprising at least partly filling the gap (15) between the elements (1, 2) after having bonded the elements.

11. Method as claimed in any of the preceding claims, wherein the protrusions and holes are dimensioned and aligned so that a wall (17) of the hole (14) is spaced from the outer surface (18) of the protrusion (7).

12. Method as claimed in claim 11, wherein a spacing (16) between the wall (17) of the hole (14) and the protrusion (17) is at least partly filled.

13. Method as claimed in any of the preceding claims, wherein the protrusion (7) is formed on a top surface pad (6) provided at the first front main surface (4) of the first element (1).

14. Method as claimed in any of the preceding claims, furthermore comprising forming a layer of bonding material on top of the protrusion (7) so as to improve the bonding of the protrusion with the metal pad (12,13)

15. Method as claimed in claim 14, wherein the bonding material comprises solder material.

16. Method as claimed in any of the preceding claims, wherein the material of an upper portion of the protrusion (7) differs from the material of a lower portion (20) of the protrusion.

17. Method as claimed in any of the preceding claims, wherein bonding the protrusion and metal pad involves a heat treatment, a compression treatment or a thermo-compression treatment.

18. Method as claimed in 17, wherein bonding the protrusion and metal pad involves a soldering treatment.

19. A semiconductor device comprising at least a first element and a second element, the second element being aligned with and bonded to the first element according to a method as in any of the previous claims.

20. Semiconductor device (3) comprising at least a first element and a second element aligned and bonded to the first element, the device comprising:
a first element (1) with at least one protrusion (7), the first element (1) having a first front main surface (4) and a first back main surface (5) and the protrusion being formed at the first front main surface (4);
a second element (2) having a second front main surface (8) and a second back main surface (9), the second element (2) including a front portion (10) located at the second front main surface (8) and a back portion (11) located at the second back main surface (9), the front portion (10) comprising a back-end-of-line (BEOL) interconnection structure comprising at least one metal pad (12,13) on the second front main surface (8) of the front portion (10) or in the front portion (10), at least one blind hole (14) being provided in the second element (2), the hole (14) extending from the second back main surface (9) to the metal pad (12,13) thereby exposing the metal pad,
wherein said at least one protrusion (7) is aligned with said at least one hole and received therein, the at least one protrusion (7) being bonded to the at least one metal pad (12,13), so that the at least one protrusion (7) makes electrical contact with the at least one metal pad (12,13) and the first element (1) is bonded to the second element (2).

21. Semiconductor device as claimed in claim 20, wherein also the first element (1) includes a front portion (30) located at the first front main surface (4) and a back portion (31) located at the first back main surface (5), the front portion (30) comprising a further back-end-of-line (BEOL) interconnection structure.

22. Semiconductor device as claimed in claim 21, wherein also the first element (1) comprises at least one further blind hole (22), the further blind hole (22) extending from the back main surface (5) to a metal pad (23,24) thereby exposing the metal pad, wherein the further blind hole (22) has received at least one protrusion (7) of a further first element (1').

23. Semiconductor device as claimed in claim 22, wherein the metal pad is a metal pad (24) on the first front main surface (8) of the front portion (10) of the first element (1).

24. Semiconductor device as claimed in claim 23, wherein the metal pad is an additional metal pad (23) provided in the front portion (30) of the first element (1).

25. Semiconductor device as claimed in any of the claims 20-24, comprising a stack of more than two elements (1,2,1').

26. Semiconductor device as claimed in any of the claims 20-25, wherein the at least one blind hole extends entirely through the back portion (11) and at least partly through the front portion (10) of the second element (2).

27. Semiconductor device as claimed in any of the claims 20-26, wherein the height of the protrusion (7) is larger than the height of the back portion (11) of the second element (2).

28. Semiconductor device as claimed in any of the claims 20-27, wherein the first and second element (1,2) are mutually bonded only by their protrusions (7) and holes (14).

29. Semiconductor device as claimed in any of the claims 20-28, comprising a gap (15) between the second back main surface (9) of the second element (2) and the first front main surface (4) of the first element (1).

30. Semiconductor device as claimed in claim 29, wherein the gap (15) is at least partly filled with filler material.

31. Semiconductor device as claimed in any of the claims 20-30, wherein the protrusions and holes are dimensioned so that the wall (17) of the hole (14) is spaced from the outer surface (18) of the protrusion (7).

32. Semiconductor device as claimed in claim 29 and 31, wherein a spacing (16) between the wall (17) of the hole (14) and the outer surface (18) of the protrusion (7) is at least partly filled.

33. Semiconductor device as claimed in any of the claims 20-32, wherein the protrusion (7) is formed on a top surface pad (6) provided at the front surface (4) of the first element (1).

34. Semiconductor device as claimed in any of the claims 20-33, wherein an improved bonding of the protrusion with the metal pad (12,13) is obtained by a layer of bonding material.

35. Semiconductor device as claimed in claim 34, wherein the bonding material comprises solder material.

36. Semiconductor device as claimed in any of the claims 20-35, wherein the bonding between the protrusion and the metal pad has been performed by means of a heat treatment, a compression treatment or a thermo-compression treatment.

37. Semiconductor device as claimed in any of claims 20-26, wherein the back portion (11) of the second element (2), comprises a front-end-of-the-line (FEOL) structure including active components such as transistors and resistors, to be interconnected by wiring in the BEOL portion (10,30) of the respective element.

38. Semiconductor device as claimed in any of claims 20-37, wherein the protrusions are non-deformable.

39. Semiconductor device as claimed in any of claims 20-37, wherein the protrusions form electrical interconnects between the stacked elements (1,2,1').
